Europäisches Patentamt

European Patent Office

Office européen des brevets

(19)

(11) Veröffentlichungsnummer: **0 043 586**

**B1**

(12)

# EUROPÄISCHE PATENTSCHRIFT

(45) Veröffentlichungstag der Patentschrift:
08.04.87

(51) Int. Cl.⁴: **H 05 K 3/22**, B 23 K 11/32

(21) Anmeldenummer: **81105265.3**

(22) Anmeldetag: **07.07.81**

(54) **Vorrichtung zur Reparatur von Leiterbahnunterbrechungen.**

(30) Priorität: **08.07.80 DE 3025875**

(43) Veröffentlichungstag der Anmeldung:
**13.01.82 Patentblatt 82/2**

(45) Bekanntmachung des Hinweises auf die Patenterteilung:
**08.04.87 Patentblatt 87/15**

(84) Benannte Vertragsstaaten:
**FR GB**

(56) Entgegenhaltungen:
**DE-A-2 251 997**
**US-A-2 463 129**
**US-A-4 135 630**

**Feinwerktechnik, 75. Jahrgang 1971, Heft 5, Seiten 201-206**

(73) Patentinhaber: **Siemens Aktiengesellschaft Berlin und München, Wittelsbacherplatz 2, D-8000 München 2 (DE)**

(72) Erfinder: **Thorwarth, Rüdiger, Tillystrasse 4, D-8019 Glonn (DE)**

EP 0 043 586 B1

## Beschreibung

Die Erfindung betrifft eine Vorrichtung zur Reparatur von Leiterbahnunterbrechungen auf Leiterplatten durch Mikro-Widerstandsschweißen mit als Spaltelektroden ausgebildeten Aufsetzelektroden, wobei eine Unterbrechung mit einem spezifischen Formteil überbrückt wird.

Bei den neuen Generationen von Leiterplatten verlaufen die Leiterbahnen nicht mehr geradlinig, sondern sind mäanderartig in trapezförmigen Leiterzügen ausgebildet. Die durch Ätzen hergestellten Leiterbahnen haben zum Beispiel eine Höhe von 30 µm und eine Breite von 120 bis 150 µm. Die Basislänge eines Trapezes ist z. B. 1,20 mm.

Bei dem Fertigungsprozeß können an den Leiterbahnen Unterbrechungen auftreten. Da die Leiterplatten nach dem Bestücken mit Bauteilen einem Lötprozeß unterworfen werden, muß die Reparatur der Leiterbahnen mit einem Verfahren durchgeführt werden, bei dem sichergestellt ist, daß durch die beim Löten auftretenden Temperaturen die Reparaturstellen keinen Schaden erleiden und sich die Verbindungen nicht wieder lösen. Ein solches Verfahren ist das Mikro-Widerstandsschweißen. In der Zeitschrift Feinwerktechnik, 75, 1971, Heft 5, Seite 201 - 206 ist ein Verfahren beschrieben, bei dem durch Mikro-Widerstandsschweißen mit einem Konstantspannungsgerät und Spaltelektroden unter Verwendung von Nickelbändern oder -drähten eingeschnürte oder unterbrochene Leiterbahnen auf durchkontaktierten Leiterplatten repariert werden.

Bei geraden Leiterbahnen wurde die Unterbrechung durch ein geeignetes Reparaturband überbrückt, welches durch Aufsetzelektroden nacheinander an beiden Seiten der Unterbrechung aufgeschweißt wurde. Die Positionierung erfolgte dabei durch einen separaten Saugrüssel, der nach der Herstellung des ersten Schweißpunktes weggefahren wurde.

Der Erfindung liegt die Aufgabe zugrunde, zur Reparatur von Leiterbahnunterbrechungen auf Leiterplatten eine Vorrichtung zu konzipieren, die gleichzeitig die lagerichtige Positionierung der zu verschweißenden Teile ermöglicht und dadurch das bekannte Verfahren vereinfacht.

Die der Erfindung zugrundeliegende Aufgabe wird mit einer eingangs definierten Vorrichtung dadurch gelöst, daß ein dreiteiliges Elektrodensystem vorgesehen ist, das aus einer zentrischen, mit einem Vakuumanschluß zum Ansaugen des Formteils ausgestatteten Innenelektrode besteht, um die konzentrisch zwei halbkreisförmige Außenelektroden angeordnet sind, die beim Schweißvorgang jede das Formteil auf einer Seite der Leiterbahnunterbrechung kontaktieren, daß diese Elektroden jeweils durch einen Luftspalt elektrisch voneinander getrennt und ferner unabhängig voneinander mechanisch gefedert sind. Mit dieser Vorrichtung wird erreicht, daß gleichzeitig die Innenelektrode mittels Saugluft das Formteil übernehmen und damit zur Positionierung beitragen kann. Auf diese Weise wird kein zusätzlicher Saugrüssel benötigt.

Nach einer Weiterbildung der Erfindung sind die drei Elektroden an die Sekundärstromkreise von zwei Stromimpulsquellen angeschlossen. Beim Auslösen der zeitlich voneinander getrennten Schweißimpulse über einen speziellen Taktgeber hat die Innenelektrode jeweils die Funktion einer Gegenelektrode. Das hat den Vorteil, daß die für die Reparatur nötigen beiden Verbindungspunkte in einem Arbeitsgang durchgeführt werden können.

Nach einer weiteren Ausgestaltung der Erfindung sind die Innenelektrode und die Außenelektroden unabhängig voneinander bewegbar und die Innenelektrode voreilend abzusenken. Dies ermöglicht die Innenelektrode zu Positionierungszwecken heranzuziehen.

Die Erfindung wird anhand der Figuren erläutert. Es zeigen:

Figur 1 eine Elektrodenanordnung in perspektivischer Darstellung mit Stromimpulsquellen und Formteil und

Figur 2 die Elektrodenanordnung in der Seitenansicht teilweise im Schnitt mit Formteil und geschnittener Leiterplatte mit unterbrochener Leiterbahn.

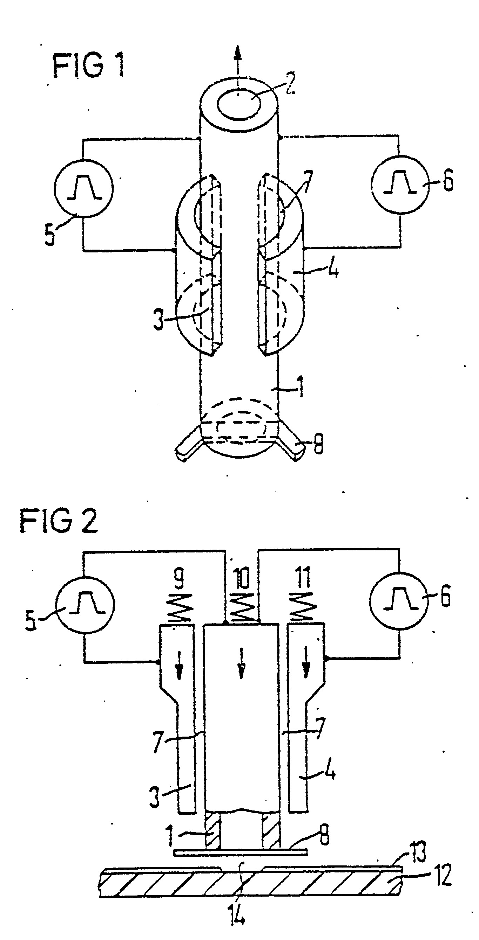

In den Figuren ist eine zentrische Innenelektrode 1 mit einer Bohrung 2 für einen Vakuumanschluß bezeichnet. Konzentrisch um diese Innenelektrode sind zwei Außenelektroden 3, 4 angeordnet. Die Innenelektrode 1 ist einerseits mit der Außenelektrode 3 mit einer Stromimpulsquelle 5 und andererseits mit der Außenelektrode 4 mit einer Stromquelle 6 verbunden. Ein Luftspalt 7 trennt die drei Elektroden elektrisch und mechanisch voneinander. An der Unterseite der Innenelektrode ist ein Formteil 8 aus Folienband angesaugt. Alle drei Elektroden sind unabhängig voneinander mit den Federn 9, 10 und 11 gefedert. Die Pfeile innerhalb der Elektroden in der Figur 2 deuten die Kraftrichtung an. In der Figur 2 ist noch auf einer Leiterplatte 12 eine Leiterbahn 13 mit einer Unterbrechung 14 dargestellt.

Für die Reparatur der Unterbrechung wird aus Folienband ein für die jeweilige Unterbrechung spezifisches Formteil ausgestanzt. Die Innenelektrode übernimmt mittels Saugluft lagerichtig von einer nicht dargestellten Stanze das Formteil. Durch die voreilende Innenelektrode 1 läßt sich das Formteil 8 deckungsgleich auf die zu reparierende Leiterbahn 13 absenken. Die mechanisch erzeugte Elektrodenkraft hält das Formteil lagerichtig auf der Reparaturstelle. Die nacheilenden Außenelektroden kontaktieren jeweils die Enden des Formteils. Beim Auslösen der zeitlich voneinander getrennten Schweißimpulse hat die Innenelektrode die Funktion von zwei Elektroden.

## Patentansprüche

1. Vorrichtung zur Reparatur von Leiterbahnunterbrechungen (14) auf Leiterplatten (12) durch Mikro-Widerstandsschweißen mit als Spaltelektroden ausgebildeten Aufsetzelektroden, wobei eine Unterbrechung (14) mit einem spezifischen Formteil (8) überbrückt wird, dadurch gekennzeichnet, daß ein dreiteiliges Elektrodensystem (1, 3, 4) vorgesehen ist, das aus einer zentrischen, mit einem Vakuumanschluß (2) zum Ansaugen des Formteils (8) ausgestatteten Innenelektrode (1) besteht, um die konzentrisch zwei halbkreisförmige Außenelektroden (3, 4) angeordnet sind, die beim Schweißvorgang jede das Formteil (8) auf einer Seite der Leiterbahnunterbrechung (14) kontaktieren, daß diese Elektroden jeweils durch einen Luftspalt (7) elektrisch voneinander getrennt und ferner unabhängig voneinander mechanisch gefedert (9, 10, 11) sind.

2. Vorrichtung nach Anspruch 1, dadurch gekennzeichnet, daß die drei Elektroden (1, 3, 4) an die Sekundärstromkreise von zwei Stromimpulsquellen (5, 6) angeschlossen sind, die über einen speziellen Taktgeber angesteuert werden.

3. Vorrichtung nach Anspruch 1, dadurch gekennzeichnet, daß die Innenelektrode (1) und die Außenelektroden (3, 4) unabhängig voneinander bewegbar sind und die Innenelektrode voreilend abgesenkt wird.

4. Vorrichtung nach Anspruch 1, dadurch gekennzeichnet, daß die Außenelektroden (3, 4) jeweils die Enden des Formteiles (8) kontaktieren, wobei beim Auslösen der zeitlich voneinander getrennten Schweißimpulse die Innenelektrode (1) die Funktion einer Gegenelektrode hat.

## Claims

1. A device for repairing ruptures (14) on printed circuit boards (12) by micro-resistance-welding by means of contact electrodes which are designed as gap electrodes, where a rupture (14) is bridged by means of a specific shaped part (8), characterised in that there is provided a three-part electrode system (1, 3, 4) which consists of a central inner electrode (1) which is equipped with a vacuum contact (2) for the suction of the shaped part (8) and around which two semi-circular outer electrodes (3, 4) are concentrically arranged, which electrodes (3, 4) respectively contact the shaped part (8) on one side of the rupture (14) of the printed circuit board during the welding process, that said electrodes are electrically separated from one another by an air gap (7) and further mechanically spring-suspended (9, 10, 11) independently of one another.

2. A device as claimed in Claim 1, characterised in that the three electrodes (1, 3, 4) are connected to the secondary circuits of two current pulse sources (5, 6) which are controlled by a specific clock pulse generator.

3. A device as claimed in Claim 1, characterised in that the inner electrode (1) and the outer electrodes (3, 4) can be moved independently of one another, and the inner electrode is lowered in advance of the others.

4. A device as claimed in Claim 1, characterised in that the outer electrodes (3, 4) respectively contact the ends of the shaped part (8), and the inner electrode (1) has the function of a counterelectrode during triggering of the welding pulses, which are separated from one another in terms of time.

## Revendications

1. Appareil pour réparer des interruptions (14) de pistes conductives sur des plaques à circuits imprimés (12), par microsoudage par résistance au moyen d'électrodes à appliquer, réalisées sous forme d'électrodes divisées, dans lequel une interruption (14) est shuntée par une pièce spécifique façonnée (8), caractérisé en ce qu'il comprend un système d'électrodes en trois parties (1, 3, 4), qui est constitué d'une électrode intérieures (1) centrale, pourvue d'un raccordement (2) d'application du vide pour aspirer la pièce façonnée (8), autour de laquelle sont disposées, concentriquement, deux électrodes extérieures semi-circulaires (3, 4) qui, lors de l'opération de soudage, viennent chacune en contact avec la pièce façonnée (8), de part et d'autre de l'interruption (14) de la piste conductive, et que ces électrodes sont électriquement séparées l'une de l'autre par un intervalle d'air (7) et sont, en plus, suspendues mécaniquement (9, 10, 11) de façon indépendante l'une de l'autre.

2. Appareil selon la revendication 1, caractérisé en ce que les trois électrodes (1, 3, 4) sont connectées aux circuits secondaires de deux sources d'impulsions de courant (5, 6) qui sont attaquées par un générateur de rythme particulier.

3. Appareil selon la revendication 1, caractérisé en ce que l'électrode intérieure (1) et les électrodes extérieures (3, 4) sont déplaçables indépendamment l'une de l'autre et que l'électrode intérieure peut être abaissée en avance.

4. Appareil selon la revendication 1, caractérisé en ce que les électrodes extérieures (3, 4) viennent en contact avec les extrémités de la pièce façonnée (8) et l'électrode intérieure (1) a la fonction d'une contre-électrode au déclenchement des impulsions de soudage, lesquelles sont mutuellement séparées dans le temps.

# FIG 1

# FIG 2